Europäisches Patentamt

European Patent Office

Office européen des brevets

(11) Publication number: 0 230 766
A1

## (12) EUROPEAN PATENT APPLICATION

(21) Application number: 86309951.1

(22) Date of filing: 19.12.86

(51) Int. Cl.4: G01R 1/067 , G01R 31/28

A request for correction of the description has been filed pursuant to Rule 88 EPC. A decision on the request will be taken during the proceedings before the Examining Division (Guidelines for Examination in the EPO, A-V, 2.2).

(30) Priority: 23.12.85 US 812480

(43) Date of publication of application:
05.08.87 Bulletin 87/32

(84) Designated Contracting States: ·
DE FR GB NL

(71) Applicant: TEKTRONIX, INC.
Tektronix Industrial Park D/S Y3-121 4900
S.W. Griffith Drive P.O. Box 500
Beaverton Oregon 97077(US)

(72) Inventor: Fleason, Reed
9615 N.W. Skyline Blvd.
Portland Oregon 97231(US)
Inventor: Strid, Eric W.
2433 N.W. 83rd Place
Portland§Oregon 97229(US)
Inventor: Flegal, Robert T.
13155 S.W. Datmoor Court
Beaverton Oregon 97005(US)
Inventor: McCamant, Angus J.
1010 S.W. 193rd Court
Aloha§Oregon 97006(US)

(74) Representative: Baillie, Iain Cameron et al
c/o Ladas & Parry Isartorplatz 5
D-8000 München 2(DE)

(54) Wafer probes.

(57) A wafer probe comprises a support member having an end region which is shaped to permit the end region to be brought into close proximity with a component under test. An amplifier is mounted on the support member at its end region. A conductive probe element is attached to the amplifier and is electrically connected to the amplifier's input terminal. A transmission line is connected to the amplifier's output terminal for transmitting signals from the amplifier to a measurement instrument.

## WAFER PROBES

This invention relates to wafer probes.

The Government has rights in this invention pursuant to Contract No. F33615-C-1774 awarded by the Department of the Air Force.

### Background of the Invention

In fabrication of integrated circuit chips, it is conventional to form many identical chips concurrently on a common wafer of semiconductor material, and subsequently dice the wafer into individual chips for packaging. It is well-known to use a wafer probe in order to test the individual chips prior to dicing and packaging.

A wafer probe is described in U. S. Patent Application Serial No. 318,084 filed November 4, 1981. That wafer probe comprises a plate-like substrate member of dielectric material. In use, the substrate member is mounted at one end in a probe station, and it carries several probe elements, such as gold beads, at its opposite end. The probe elements are connected to a measurement instrument by transmission lines formed on the substrate member. In order to carry out a test, the probe elements are brought into contact with pads of an integrated circuit under test, and the signals at those pads are transmitted to the measuring instrument.

A disadvantage of the wafer probe described in U. S. Patent Application Serial No. 318,084 filed November 4, 1981 is that the relatively low input impedance of the transmission lines (e.g. 50 ohms) results in the possibility that the testing operation might disturb significantly the signal level at the probed pads.

An active wafer probe using an amplifier implemented in silicon and spaced from the probe station is manufactured by G. G. B. Industries of Gillette, New Jersey.

E. Strid and K. Gleason, "A DC -12GHz Monolithic GaAsFET Distributed Amplifier", IEEE Transactions on Microwave Theory and Techniques, vol. MTT-30, No. 7, pp. 969-975, July 1982, discloses a wafer probe and suggests that passive or active circuit elements may be mounted on the probe tip.

### Summary of the Invention

A wafer probe in accordance with the invention preferably comprises a plate-like substrate member having two opposite ends. In use, the substrate member is mounted at one end in a probe station. The substrate member carries at its opposite end an integrated circuit amplifier having a high input impedance. A probe element is attached to the amplifier and is electrically connected to the amplifier's input terminal. The amplifier's output terminal is connected by way of a transmission line to a measurement instrument.

### Brief Description of the Drawings

For a better understanding of the invention, and to show how the same may be carried into effect, reference will now be made, by way of example, to the accompanying drawing the single figure of which is a partly broken-away perspective view of a wafer probe embodying the present invention.

### Detailed Description

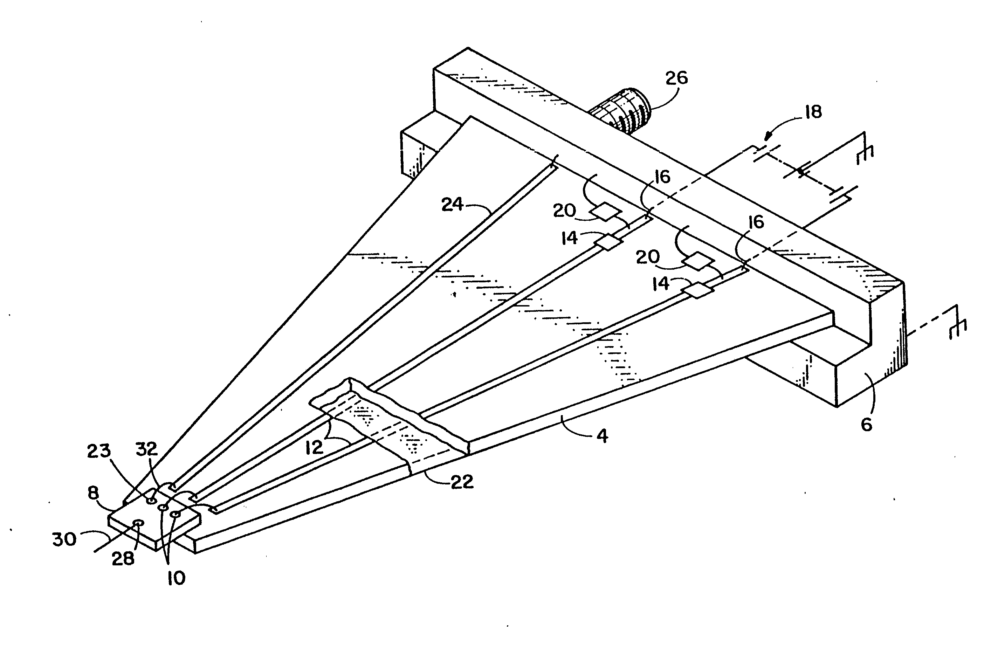

The wafer probe shown in FIG. 1 comprises a substrate 4 of ceramic material. The substrate is generally triangular when viewed from above, and is attached at its base to a mounting block 6. At its apex, the substrate 4 carries a monolithic integrated circuit amplifier 8. The amplifier is a three stage source follower circuit implemented in gallium arsenide and has an input impedance of about 100 megohms in parallel with about 20 fF. The amplifier has power supply terminals 10 that are connected through microstrip conductors 12 and 50 ohm resistors 14 to the terminals 16 of a D. C. voltage supply 18. The substrate 4 carries at its underside a continuous layer 22 of conductive material which is grounded by way of the block 6. The microstrip conductors 12 and the layer 22 constitute two power-supply transmission lines each having a characteristic impedance of 50 ohms. The transmission lines are terminated in their characteristic impedance by the resistors 14. By-pass capacitors 20 are connected between the terminals 16 and the mounting block 6. Therefore, perturbations in the power supply voltages are not transmitted to the amplifier 8.

A third microstrip conductor 24 is connected to the output terminal of the amplifier 8 by a short - (e.g., about 0.04 mm) bond wire 32 and extends between the amplifier 8 and the central conductor of a coaxial connector 26. The conductor 24 and the layer 22 together constitute a third transmission line. The coaxial connector is used for connecting the third transmission line to a measurement and display instrument, such as a sampling oscilloscope. The amplifier also has an input terminal 28, which is connected to a conductive probe element 30. The probe element 30 may comprise, for example, a 0.018 mm diameter bond wire that is attached to the input terminal pad of the amplifier 8.

In use, the illustrated probe is mounted by way of the mounting block in a probe station, and the probe is positioned so that the probe element 30 contacts a node of interest in a circuit under test. A ground connection and other power supply voltages are connected to the circuit under test by way of other probes of conventional design. Signals developed at the node of interest are applied to the input terminal of the amplifier 8 by way of the probe element 30 and are transmitted by way of the output terminal, the bond wire 32, the transmission line 24 and the connector 26 to the measurement and display instrument (not shown). Through use of the amplifier 8, a very high input impedance is presented to the node of interest, and accordingly the operation of the circuit under test is not perturbed significantly by the testing operation. The amplifier 8 has a relatively low output impedance and accordingly is well matched to the transmission line 24. Because the bond wire 32 is the only non-transmission line conductor between the amplifier 8 and the measurement and display instrument, and is very short, the output signal of the amplifier suffers very little degradation.

As noted previously, the input impedance of the amplifier 8 is very high. This stems from the fact that the value of $G_m{}^*Z_g$ for a field effect transistor implemented in gallium arsenide (where $G_m$ is the transconductance of the transistor and $Z_g$ is its gate impedance) is high. $G_m{}^*Z_g$ is proportional to $F_t$, or the frequency for unity current gain, of the transistor. The value of $F_t$ for the transistors used in the amplifier 8 is about 13 GHz, and any material could be used for implementation of the amplifier 8 provided that a field effect transistor fabricated in the material has a value of $F_t$ of at least about 13 GHz.

Because the input impedance of the amplifier 8 is very high, the inductance of the probe element 30 does not degrade significantly the input signal applied to the probe element. Nevertheless, in order to minimize reception of stray signals by virtue of the probe element 30 acting as an antenna, the length of the probe element must be kept to a minimum. It is therefore desirable that the probe element be less than about 1.25 mm long, and it is preferred that it be less than about 0.25 mm long. Consequently, the inductance of the probe element is small also and does not contribute to signal degradation.

It is preferred that the amplifier circuit be a three stage source follower amplifier, because although that circuit has a low gain it has relatively good linearity. A buffered-FET logic amplifier has the advantage of a higher gain, but the poor linearity of that circuit renders it unsuitable for accurate measurements on analog signals.

Because the amplifier 8 has a very high input impedance, the conductor that connects the circuit under test to ground can have quite a high impedance and therefore can be quite long. This makes it possible for the ground connection to the circuit under test to be made by way of a separate probe, rather than by way of a second probe element carried by the substrate 4.

It is necessary to protect the input stage of the amplifier 8 against large input voltages. This may be accomplished by use of resistors and diodes that limit the input signal to the supply voltages.

It will be appreciated that the present invention is not restricted to the particular probe head that has been described and illustrated, and that variations may be made therein without departing from the scope of the invention as defined in the appended claims, and equivalents thereof. For example, instead of microstrip transmission lines, with the signal and ground conductors on opposite sides of the substrate 4, coplanar transmission lines may be used. Alternatively, a microtube transmission line may be used for connecting the output terminal 23 of the amplifier to the measurement instrument. In this case, the amplifier 8 would be mounted near the end of the microtube transmission line and wires would be used to connect the amplifier to the bias supply 18. The by-pass capacitors 20 would be mounted near the amplifier. It is not essential to the invention that a monolithic integrated circuit be used for the amplifier 8, since a hybrid circuit may be used instead.

**Claims**

1. A wafer probe comprising a support member having an end region which is shaped to permit the end region to be brought into close proximity with a component under test, an amplifier mounted on the support member at the end region thereof and having an input terminal and an output terminal, a conductive probe element attached to the amplifier and electrically connected to said input terminal, and a transmission line connected to the output terminal for transmitting signals from the amplifier to a measurement instrument.

2. A probe according to claim 1, wherein the support member is a plate-form member having first and second opposite main faces, and said transmission line is formed by a strip of conductive material deposited on the first main face of the support member and a layer of electrically conductive material deposited on one of said main faces of the support member in electrically-insulating relationship with respect to said strip.

3. A probe according to claim 2, wherein said layer of conductive material is deposited on the second main face of the support member.

4. A probe according to claim 3, wherein the amplifier has first and second power supply terminals and the probe comprises first and second conductors for connecting the power supply terminals respectively to a power supply, said first and second conductors comprising strips of conductive material deposited on the first main face of the support member, and by-pass capacitors spaced from said end region of the support member and connected between said first and second conductors and said layer of electrically conductive material.

5. A wafer probe according to claim 1, wherein the amplifier is a multi-stage source follower amplifier.

6. A probe according to claim 1, wherein the amplifier is a monolithic buffered FET logic amplifier.

7. A probe according to claim 1, wherein the probe element has a length of from about 0.25 mm to about 1.25 mm and a thickness of about 0.018 mm.

8. A probe according to claim 1, wherein the amplifier has first and second power supply terminals and the probe comprises first and second conductors for connecting the power supply terminals respectively to a power supply.

9. A probe according to claim 8, comprising first and second by-pass capacitors connected between the first and second conductors and a reference potential source.

10. A probe according to claim 8, comprising a third conductor that is connected to the reference potential source, said first and second conductors forming respective transmission lines with the third conductor, and the probe also comprising first and second resistors connected to the first and second conductors respectively and each having a resistance value equal to the characteristic impedance of the transmission lines.

11. A probe according to claim 1, wherein the amplifier has first and second power supply terminals and the probe comprises first and second transmission lines for connecting the power supply terminals respectively to a power supply by way of first and second resistors each having a resistance value equal to the characteristic impedance of the transmission lines.

12. A wafer probe according to claim 1, wherein the amplifier has first and second power supply terminals and the probe comprises first and second by-pass capacitors connected between the power supply terminals respectively and a reference potential source.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 161 692 (J.W. TARZWELL) * column 2, line 60 - column 3, line 25; column 6, line 51 - column 7, line 4; figure 11 * | 1 | G 01 R 1/067 G 01 R 31/28 |
| A | | 2-12 | |
| | --- | | |
| A | EP-A-0 131 375 (TEXAS INSTRUMENTS) * page 5, lines 14-27; figure 1 * | 1 | |
| | ----- | | |

| | TECHNICAL FIELDS SEARCHED (Int. Cl.4) |
|---|---|
| | G 01 R 1/067 G 01 R 1/073 G 01 R 31/28 |

The present search report has been drawn up for all claims

| Place of search | Date of completion of the search | Examiner |
|---|---|---|
| BERLIN | 18-03-1987 | LEMMERICH J |

IAIN C. BAILLIE
PETER D. GALLOWAY
JOHN RICHARDS
    (MEMBERS NEW YORK BAR)

PAUL R. MADGWICK
MARTYN W. MOLYNEAUX
    (U. K. PATENT AGENTS)

PROFESSIONAL REPRESENTATIVES
BEFORE THE EUROPEAN
PATENT OFFICE

## ISARTORPLATZ 5
## 8000 MUNICH 2

TELEPHONE: (0 89) 22 67 35/36
Facsimile (Group 2 & 3): (0 89) 22 97 34
CABLES: LAWLAN MUNICH
TELEX: 5-28 474 lawln d

52-54 HIGH HOLBORN
LONDON, WC1V 6RR
———
26 WEST 61st STREET,
AT LINCOLN CENTER
NEW YORK, N. Y. 10023
———
104 SOUTH MICHIGAN AVE
CHICAGO ILL 60603
———
3600 WILSHIRE BLVD
LOS ANGELES CALIF 90010

The European Patent Office,
Postbus 5818,
2280, HV Rijsijk ZH,
NETHERLANDS.

30th January 1987.

Dear Sirs,

Re: European Patent Appln. No. 86309951.1
TEKTRONIX, INC.
Our Ref: M.3730/MWM

In connection with the above application, we request that an obvious clerical error be corrected under Rule 88 as follows:-

Page 3, line 28 "0.04 mm" to be amended to "0.4 mm"

We look forward to hearing from you that correction of this clerical error has been effected.

Please acknowledge safe receipt of this letter by returning the attached postal card.

Yours faithfully,
LADAS & PARRY

MARTYN W. MOLYNEAUX
Professional Representative.

MWM/mmh

W.G.F. VAN ROSMALEN
☎ (070) 403104